# EUROPÄISCHE PATENTANMELDUNG

(11) **EP 2 490 250 A1**
(43) Veröffentlichungstag der Anmeldung: **22.08.2012**
(21) Anmeldenummer: 12155193.1
(22) Anmeldetag: 13.02.2012
(51) Int. Cl.: H01L 21/56, H01L 23/31, B81C 1/00, G01L 9/00

(54) **Moldmodul mit Sensorelement**

(30) Priorität: 18.02.2011 DE 102011004381
(71) Anmelder: Robert Bosch GmbH, 70442 Stuttgart (DE)
(72) Erfinder: Touhent, Hassene, 72762 Reutlingen (DE); Voegele, Georg, 88085 Langenargen (DE); Keil, Matthias, 72764 Reutlingen (DE)

(57) **Zusammenfassung**

Die Erfindung betrifft Moldmodule mit Sensorelementen und/oder empfindlichen Bauelementen sowie Verfahren und Werkzeuge zur Herstellung derartiger Moldmodule. Ein erfindungsgemäßes Werkzeug (100) zur Herstellung eines Moldmoduls (102) mit einem Schaltungsträger (104) und mindestens einem von dem Schaltungsträger getragenen Bauelement (106, 108, 110), wobei eine Moldmasse (114) den Schaltungsträger (104) umschließt, umfasst einen Sperraufsatz (124) zum Aufsetzen auf den Schaltungsträger (104), wobei der Sperraufsatz (124) derart ausgebildet ist, dass mindestens ein Bereich (116) auf dem Schaltungsträger (104) von der Moldmasse (114) freigehalten wird und der Bereich (116) mindestens ein Bauelement (110) derart umfasst, dass das Bauelement (110) freiliegend bleibt.

## Beschreibung

### Stand der Technik

Die vorliegende Erfindung betrifft Moldmodule, insbesondere Moldmodule mit Sensorelementen und/oder empfindlichen Bauelementen sowie Verfahren und Werkzeuge zur Herstellung derartiger Moldmodule.

Moldmodule bzw. Elektronikpackages umfassen in der Regel mindestens einen Schaltungsträger, beispielsweise eine Leiterplatte bzw. ein PCB ("Printed Circuit Board"), wobei der Schaltungsträger mindestens ein Bauelement, i.d.R. aber eine größere Anzahl an Bauelementen trägt. Die Bauelemente können bspw. Schaltelemente (Kondensatoren, Widerstände, Transistoren), integrierte Schaltungen bzw. ICs ("Integrated Ciruits") oder Chips oder auch Sensorelemente umfassen wie etwa Drucksensoren, Temperatursensoren. Weitere Beispiele für Bauelemente sind Sende- und/oder Emfpfangseinheiten, beispielsweise Antennenstrukturen, RFIDs (Radio Frequency Identification"). Der Schaltungsträger mitsamt den Bauelementen wird bei der Herstellung des Moldmoduls vollständig von einer Moldmasse wie etwa einem Fließ- oder Kunstharz umschlossen, lediglich externe Anschlüsse werden nach außen geführt. So werden die Schaltungen vor Beeinträchtigungen durch mechanische Beschädigung, Verschmutzung oder dergleichen geschützt. Moldmodule werden beispielsweise in rauen Umgebungen wie etwa im Automotivebereich eingesetzt.

Die Herstellung von robusten Moldmodulen für den Einsatz in rauer Umgebung erfolgt heutzutage kostengünstig beispielsweise über bekannte Gießtechniken als Formkunststoffverkapselungen. Die Herstellung eines Moldpackages geschieht unter hohem Druck und beispielsweise über mehrere Stunden bei Temperaturen von bspw. 180°C. Empfindliche Bauelemente können daher nicht verbaut werden; dies betrifft beispielsweise druck-und/oder temperaturempfindliche Bauelemente wie etwa ELKOs ("Elektrolytkondensatoren"). Ebenso können Bauelemente, die einen Kontakt zur Umgebung brauchen, nicht verbaut werden, weil dieser durch die Moldmasse unterbunden würde. Das betrifft bspw. Drucksensoren, die eine Membran aufweisen, die der Umgebungsatmosphäre ausgesetzt sein muss.

Aus der DE 42 19 575 A1 (dortige Fig. 1) ist ein Harzformverfahren zur Herstellung einer formverkapselten Drucksensor-Halbleitervorrichtung bekannt, bei dem auf einem Drucksensor-Chip ein Dammharz vorgesehen wird. Das Harz wird an der Außenseite der druckaufnehmenden Membran des Sensors aufgebracht. Auf den Dammharz wird ein Druckstempel aufgedrückt, welcher beweglich in einer Ausnehmung eines Formoberteils angeordnet ist. Beim Einfüllen eines Epoxydharzes in die Form blockiert das Dammharz im Zusammenwirken mit dem Druckstempel das Einfließen des Harzes in einen Raumbereich oberhalb der Membran. Hierdurch wird in der formverkapselten Vorrichtung ein Fenster ausgebildet, welches nur die Membran des Drucksensor-Chips freilässt.

Dieses Verfahren ermöglicht die Bereitstellung eines Moldmoduls mit einem Drucksensor im Kontakt mit der Umgebung. Allerdings erfordert die Aufbringung des Dammharzes an der Außenseite der Membran eine hohe Genauigkeit. Weiterhin muss der Druck, mit dem der Druckstempel auf dem Dammharz aufgesetzt wird, sehr genau dosiert werden, um eine Zerstörung der Membran zu vermeiden. Das Verfahren ist dementsprechend aufwendig und teuer.

Ebenfalls in der DE 42 19 575 A1 wird (in den dortigen Fign. 2 - 4) ein weiteres Verfahren zur Herstellung einer formverkapselten Drucksensorvorrichtung beschrieben, bei dem ein Drucksensorelement zunächst vollständig mit einem Epoxidharz verkapselt wird. In einem weiteren nachgelagerten Prozessschritt wird dann das Epoxidharz lokal oberhalb einer Membran des Drucksensors auf mechanische Weise entfernt. Dies kann bspw. durch ein Sandstrahlverfahren geschehen, wobei zur Vermeidung einer Beschädigung der Membran eine dünne Schicht des Harzes stehen gelassen wird. Diese dünne Schicht wird sodann chemisch beseitigt, beispielsweise durch ein Wegätzen oder sonstiges Auflösen des Harzes. Bei einer Variante dieses Verfahrens ist ein Formteil so geformt, dass oberhalb der Membran des Drucksensors von vornherein nur eine vergleichsweise dünne Schicht von Epoxidharz gebildet wird. Hierbei kann der Schritt des mechanischen Entfernens entfallen und es muss lediglich die dünne Schicht über der Membran lokal chemisch entfernt werden.

Auch dieses Verfahren ist durch den mindestens einen nachgelagerten Schritt des chemischen Beseitigens der Epoxidschicht aufwendig und damit teuer. Desweiteren dürfte das Verfahren keine Lösung für den Verbau druck- und temperaturempfindlicher Bauelemente in einem Moldpackage anbieten.

### Offenbarung der Erfindung

Es besteht ein Bedarf an einem einfachen und kostengünstigen Verfahren sowie einem entsprechenden Werkzeug zur Herstellung eines Moldmoduls mit mindestens einem druck-und/oder temperaturempfindlichen Bauelement oder einem sonstigen Bauelement mit Kontakt zur Umgebung, sowie an einem derartigen Moldmodul.

Erfindungsgemäß wird ein Moldmodul vorgeschlagen, welches einen Schaltungsträger und mindestens ein vom Schaltungsträger getragenes Bauelement umfasst, wobei eine Moldmasse den Schaltungsträger umschließt. Mindestens ein Bereich auf dem Schaltungsträger ist von der Moldmasse freigehalten. Der Bereich umfasst mindestens ein Bauelement derart, dass das Bauelement freiliegt.

Bei dem Schaltungsträger kann es sich beispielsweise um eine Leiterplatte (z.B. ein PCB) handeln. Zusätzlich oder alternativ kann der Schaltungsträger ein erstes Bauelement (z.B. auf einer Leiterplatte) umfassen, wobei das erste Bauelement als zweites Bauelement das freizuhaltende Bauelement trägt. Bei dem ersten Bauelement kann es sich beispielsweise um eine weitere Leiterplatte, einen Chip, und/oder einen Materialblock (etwa einen Kühlkörper) zur mechanischen und/oder thermischen Lagerung des zweiten Bauelements handeln.

Das freizuhaltende Bauelement kann ein mechanisch und/oder thermisch empfindliches Bauelement sein, wie beispielsweise ein ELKO. Zusätzlich oder alternativ kann es sich bei dem freizuhaltenden Bauelement bzw. einem oder mehreren der freizuhaltenden Bauelemente um ein für einen Kontakt mit einer Umgebung vorgesehenes Bauelement, wie beispielsweise ein Sensorelement oder ein Sende- und/oder Empfangselement handeln. Beispielsweise kann es sich um einen Drucksensor handeln, einen Ultraschallsensor, einen RFID, eine Antennenstruktur, etc.

Erfindungsgemäß wird weiterhin ein Verfahren zur Herstellung eines Moldmoduls mit einem Schaltungsträger und mindestens einem von dem Schaltungsträger getragenen Bauelement vorgeschlagen. Das Verfahren umfasst die folgenden Schritte: Aufsetzen eines Sperraufsatzes auf den Schaltungsträger und Umschließen des Schaltungsträgers mit einer Moldmasse, wobei durch den Sperraufsatz ein Bereich auf dem Schaltungsträger von der Moldmasse freigehalten wird. Der freigehaltene Bereich umfasst mindestens ein Bauelement derart, dass das Bauelement freiliegend bleibt.

Der Sperraufsatz kann unmittelbar auf dem Schaltungsträger aufsetzen. Zusätzlich oder alternativ kann ein Aufsetzbereich auf dem Schaltungsträger definiert sein, auf dem Dammharz aufgebracht ist, wobei ein entsprechender Bereich des Sperraufsatzes auf dem Dammharz aufkommt. Zusätzlich oder alternativ kann der Sperraufsatz einen Kontaktbereich zum Kontaktieren des Schaltungsträgers bzw. Aufsetzen auf dem Schaltungsträger aufweisen, wobei der Kontaktbereich beispielsweise ebenfalls ein Harz oder ein sonstiges Material umfasst, welches in ausreichender Weise temperatur- und/oder formbeständig ist, um eine Herstellung des Moldpackages zu ermöglichen. Ein Fließharz, das einen Kontaktbereich des Sperraufsatzes bildet, kann beispielsweise so ausgebildet sein, dass es bei der Herstellung des Moldpackages zu einem gewissen Grade aufschmilzt und dann eine abdichtende Verbindung zwischen dem Sperraufsatz und dem Schaltungsträger derart bildet, dass ein Einfließen der Moldmasse in den vom Sperraufsatz abgesperrten Bereich unterbunden wird.

Das Aufsetzen des Sperraufsatzes kann entkoppelt von einem Zusammensetzen von Formteilen erfolgen, bspw. unabhängig von einem Aufsetzen eines Formoberteils auf einem Formunterteil. Der Sperraufsatz kann von oben, von unten, oder von der Seite auf den Schaltungsträger aufgesetzt werden. Der Sperraufsatz kann beispielsweise vor, gleichzeitig oder nach einem Aufsetzen bzw. Zusammenfügen von Formteilen zum Einschluss des Schaltungsträgers erfolgen.

Erfindungsgemäß wird weiterhin ein Werkzeug zur Herstellung eines Moldmoduls mit einem Schaltungsträger und mindestens einem von dem Schaltungsträger getragenen Bauelement vorgeschlagen. Eine Moldmasse umschließt den Schaltungsträger. Das Werkzeug umfasst einen Sperraufsatz zum Aufsetzen auf den Schaltungsträger, wobei der Sperraufsatz derart ausgebildet ist, dass mindestens ein Bereich auf dem Schaltungsträger von der Moldmasse freigehalten wird und wobei der Bereich mindestens ein Bauelement derart umfasst, dass das Bauelement freiliegend bleibt.

Der Sperraufsatz kann bei einer Ausführungsform eine Ausnehmung derart aufweisen, dass beim Aufsetzen des Sperraufsatzes auf dem Schaltungsträger das freizuhaltende Bauelement in die Ausnehmung aufgenommen wird. Beispielhaft kann der Sperraufsatz etwa als Hohlzylinder oder Hohl- bzw. Innenvierkant ausgebildet sein.

Der Sperraufsatz kann von weiteren Komponenten des Werkzeugs, wie beispielsweise einem Formteil, derart entkoppelt sein, dass ein abdichtendes Aufsetzen des Sperraufsatzes auf den Schaltungsträger ohne Beschädigung desselben zuverlässig erfolgen kann. Hierzu kann der Sperraufsatz beispielsweise federnd gelagert sein. Eine Federkraft kann so gewählt werden, dass der Sperraufsatz dichtend aufsetzt, ohne den Schaltungsträger zu beschädigen.

Der Sperraufsatz kann beispielsweise in eine Aussparung oder Ausnehmung eines Formteils (beispielsweise eines Formoberteils) aufnehmbar sein. Hierbei kann es sich etwa um eine Öffnung in einem Formteil handeln, durch welche der Sperraufsatz selbst oder eine Halterung oder Führung für den Sperraufsatz ganz oder teilweise passiert. Die Halterung kann beispielsweise eine federnde Halterung sein.

### Vorteile der Erfindung

Die Erfindung ermöglicht die Herstellung von Moldmodulen mit druck- und/oder temperaturempfindlichen Bauelementen und/oder solchen Bauelementen, die für ihre Funktion einen Kontakt zur Umgebung benötigen. Somit können kostengünstige Verfahren zur Kunststoffverkapselung, wie beispielsweise die Formverkapselung, für die Herstellung entsprechender Schaltungsträger zum Einsatz kommen, wodurch die Herstellung derartiger Schaltungen kostengünstiger dargestellt werden kann. Mit einer vergleichsweise einfachen Modifikation eines Moldwerkzeugs wird eine kostengünstige Herstellung von Packages mit empfindlichen Komponenten insbesondere zum Einsatz in rauer Umgebung ermöglicht.

Das erfindungsgemäße Verfahren erfordert prinzipiell keine zusätzlichen dem Giessen vor-oder nachgelagerten Verfahrensschritte. Das erfindungsgemäße Werkzeug zur Herstellung von Moldmodulen umfasst mindestens ein Sperraufsatz, der vorteilhafterweise von den sonstigen (Form-)Teilen des Werkzeugs insoweit entkoppelt ist, dass eine zuverlässige und beschädigungsfreie Sperrwirkung gegenüber dem Fließharz gewährleistet ist. Darüberhinaus sind keine weiteren Modifikationen am Formwerkzeug erforderlich.

Dadurch dass eine Sperrwirkung gegenüber der Moldmasse auf einem Schaltungsträger wie etwa einer Leiterplatte oder einem seinerseits tragenden Bauelement erfolgt, ist es nicht erforderlich, etwa ein Dammharz mit außerordentlicher Genauigkeit aufzubringen, und/oder eine Anpresskraft des Sperraufsatzes oder eines Stempels außerordentlich genau zu bemessen, um Beschädigung eines sensitiven Elementes zu vermeiden. So ist idR. eine leiterplatte oder ein Kühlkörper robuster als beispielsweise die Membran eines Drucksensors. Ist z.B. eine federnde Halterung des Sperraufsatzes an einem Formteil vorgesehen, kann die Kontaktierung des Schaltungsträgers durch den Sperraufsatz gleichzeitig mit dem Einschluss des Schaltungsträgers in die Formteile erfolgen, ohne dass hierfür zusätzliche Prozessschritte erforderlich wären.

### Kurze Beschreibung der Zeichnungen

Weitere Aspekte und Vorteile der Erfindung werden nunmehr anhand der beigefügten Figuren eingehender beschrieben; von diesen zeigt:
- Fig. 1: ein erstes Ausführungsbeispiel eines erfindungsgemäßen Moldwerkzeuges zur Herstellung eines Moldmoduls;
- Fig. 2: ein zweites Ausführungsbeispiel eines erfindungsgemäßen Moldwerkzeuges; und
- Fig. 3: in Form eines Flussdiagramms eine Arbeitsweise des in Fig. 2 gezeigten Moldwerkzeuges.

### Ausführungsformen der Erfindung

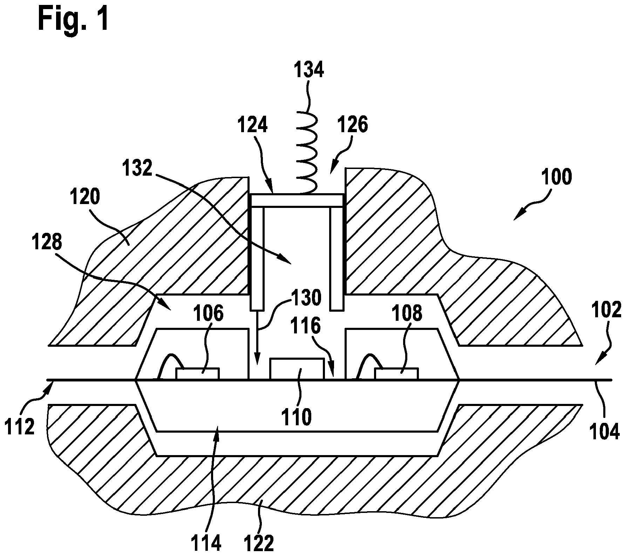

Fig. 1 zeigt in einer schematischen Schnittansicht ein erstes Ausführungsbeispiel 100 eines erfindungsgemäßen Moldwerkzeuges zur Herstellung eines Moldmoduls 102. Das Moldmodul 102 umfasst einen Schaltungsträger in Form einer Leiterplatte 104 mit darauf angebrachten Bauelementen 106, 108 und 110. Im Folgenden wird beispielhaft angenommen, dass es sich bei den Bauelementen 106 und 108 um Bauteile handelt, die den üblicherweise beim Molden auftretenden Temperaturen und Drücken gegenüber unempfindlich sind und zu ihrer Funktion keinen Kontakt zur Außenwelt benötigen, während es sich bei dem Bauelement 110 um einen Drucksensor handelt, der für seine vorgesehene Funktion Kontakt zur Umgebungsatmosphäre benötigt.

Wie in Fig. 1 angedeutet, ermöglicht das Werkzeug 100 die Herstellung des Moldpackages 102 derart, dass der größte Teil der Leiterplatte 104 bis auf externe Anschlüsse 112 von einer Moldmasse 114 umschlossen wird, wobei jedoch ein Bereich 116 auf der Leiterplatte 104 von der Moldmasse 114 freigehalten ist. Der Bereich 116 umfasst den Drucksensor 110 so, dass dieser vollständig freiliegt.

Das Moldwerkzeug 100 umfasst ein Formoberteil 120 sowie ein Formunterteil 122. Weiterhin ist ein Sperraufsatz 124 in einem Schacht 126 des Oberteils 120 vertikal bewegbar vorgesehen. Die Formteile 120 und 122 sind aus Gründen der Übersichtlichkeit von dem Moldpackage 102 abgesetzt dargestellt. Im geschlossenen Zustand schließen die Formteile 120, 122 einen Bauelemente tragenden Bereich der Leiterplatte 104 vollständig ein und bilden einen Hohlraum um die Leiterplatte 104 herum, der von eingefülltem Moldmaterial vollständig ausgefüllt wird. Vor dem Einfüllen des Harzes wird jedoch der Sperraufsatz 124 durch den Schacht 126 hindurch in Richtung des Pfeiles 130 abgesenkt, bis der Sperraufsatz 124 auf dem Schaltungsträger 104 aufsetzt. Der Sperraufsatz 124 verfügt über eine Ausnehmung 132 zur Aufnahme des Drucksensors 110. Der Hohlraum 132 ist zumindest so bemessen, dass das druckempfindliche Sensorelement 110 vollständig aufgenommen werden kann. Auf diese Weise wird verhindert, dass das Harz 114 beim Einfüllen in den Hohlraum 128 in den Bereich 116 gelangen kann. Somit bleibt das druckempfindliche Bauelement 110 von den Drücken und zumindest teilweise den Temperaturen ausgenommen, die beim Molden auf die Komponenten 106 und 108 wirken.

Die Ausnehmung 132 wird bei dem in Fig. 1 gezeigten Beispiel durch den Innenraum eines Hohlzylinders bzw. einer Sperrglocke oder einer vergleichbaren, innen hohlen Struktur gebildet. Statt eines Zylinders kann ein beliebig geformtes Element zum Einsatz kommen, wobei die Geometrie der Ausnehmung nicht zwingend mit den äußeren Abmessungen des Sperraufsatzes entsprechen muss. So kann etwa ein außen runder Zylinder eine Ausnehmung in Form eines Innenvierkants aufweisen. Ist ein Sperraufsatz im wesentlich hohl, wie der in Fig. 1 angedeutete Sperraufsatz 124, so muss dieser an seiner vom Schaltungsträger abgewandten Seite nicht verschlossen sein, soweit das Zusammenwirken des Sperraufsatzes mit weiteren Komponenten wie etwa einem Formteil ein Freihalten des Bereiches auf dem Schaltungsträger von der Moldmasse gewährleistet.

Während der Sperraufsatz in dem hier gezeigten Beispiel ein Teil, nämlich den Aufsatz 124 umfasst, kann der Sperraufsatz auch mehrere Teile umfassen, die starr oder flexibel gefügt sind.

Wie durch ein Federelement 134 angedeutet, ist das Aufsetzen des Sperraufsatzes 124 auf die Leiterplatte 104 entkoppelt vom Zusammensetzen der Formteile 120 und 122. Durch geeignete Bemessung einer von dem Element 134 vermittelten Federkraft kann ein den Bereich 116 abdichtendes Aufsetzen des Federelementes 124 ohne eine Beschädigung oder Zerstörung der Leiterplatte 104 oder des Bauelementes 110 erfolgen, ohne dass eine außerordentlich genaue Bemessung des Formoberteils 120 zur Leiterplatte 104, dem Bauelement 110 und/oder dem weiteren Formteil 122 erforderlich ist. Eine Steuerung des Moldprozesses erfolgt lediglich mit einer Genauigkeit wie bei herkömmlichen Moldprozessen auch.

Im Unterschied zu den oben geschilderten, bekannten Verfahren zur Herstellung von Moldpackages mit einem druckempfindlichen Bauteil wird das druckempfindliche Bauelement 110 nicht nur auf einem Teilbereich seiner Oberfläche sondern vollständig von der Moldmasse 114 freigehalten. Da somit das Element insgesamt beim Molden keinen hohen Drücken sowie nur entsprechend niedrigeren Temperaturen ausgesetzt ist (eine zusätzliche Kühlung des Bauelementes 110 könnte durch den Schacht 126 passiv oder aktiv erfolgen), können entsprechend empfindlichere Bauelemente mit dem erfindungsgemäßen Verfahren bzw. Werkzeug verbaut werden.

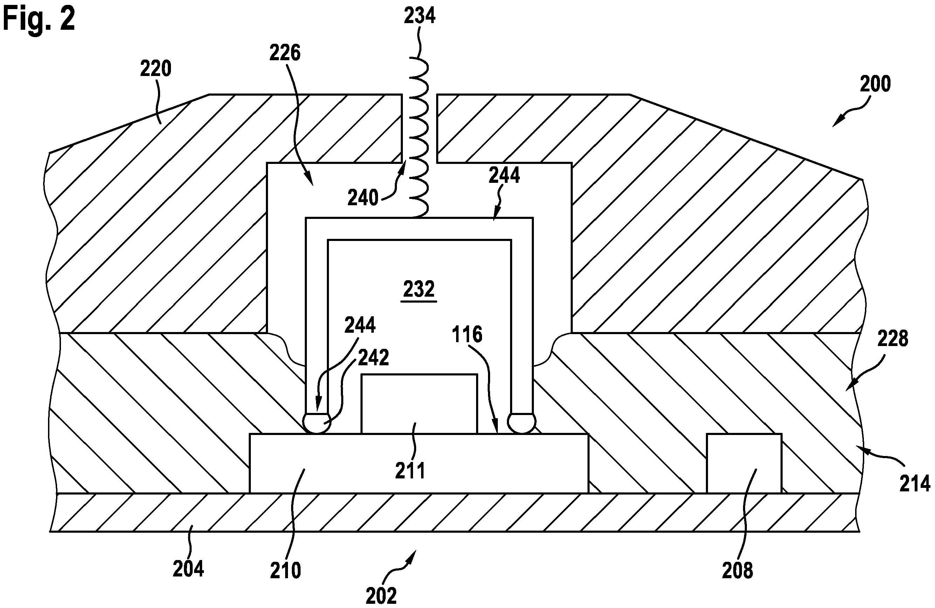

In Fig. 2 ist ein weiteres Ausführungsbeispiel 200 eines erfindungsgemäßen Werkzeuges zur Herstellung eines Moldmoduls 202 angedeutet. Das Werkzeug 200 stimmt in vielen Belangen mit dem Werkzeug 100 aus Fig. 1 überein; sofern Aspekte oder Elemente des Werkzeugs 200 nachfolgend nicht explizit beschrieben werden, ergeben sich diese sinngemäß aus entsprechenden Aspekten oder Elementen des Werkzeugs 100.

Das Werkzeug 200 umfasst ein Formoberteil 220, in das ein Sperraufsatz 224 beweglich in einem Schacht 226 aufgenommen ist. Ein Federelement 234 könnte prinzipiell durch das Formteil 220 gehalten werden, erstreckt sich jedoch zur (Fein-)Justierung durch eine Bohrung 240 in einen äußeren Bereich des Werkzeugs 200. Auf einer Leiterplatte 204 des Moldmoduls 202 sind unempfindliche Bauelemente 208 und 210 angedeutet, wobei das Bauelement 210 wiederum ein druck- und/oder temperaturempfindliches Element 211 trägt.

Das Bauelement 210 fungiert also als Schaltungsträger für die Schaltung bzw. das Bauelement 211. Bei dem Element 210 kann es sich beispielsweise um ein thermisches Ausgleichselement (ein Kühlkörper) und/oder ein elektrisches Anschlusselement für das Bauelement 211 handeln. Insbesondere ist das unterstützende Element 210, wie aus Fig. 2 ersichtlich, mit einem größeren Footprint ausgelegt als das unterstützte Bauelement 211. Dieser Aspekt kann entweder durch konstruktive Erfordernisse der Elemente 210, 211 vorgegeben sein oder kann gezielt im Hinblick auf das nachfolgend geschilderte erfindungsgemäße Moldverfahren, d.h. für die Anwendung des Moldwerkzeugs 200 ausgelegt sein.

Zum Molden wird das Formteil 220 mit einem oder mehreren weiteren Formteilen (nicht gezeigt) zusammengesetzt. Vor dem Einfüllen der Moldmasse 214 wird der Sperraufsatz 224 auf einen freizuhaltenden Bereich 216 auf dem Bauteil 210 abgesenkt. Der Sperraufsatz 224 ist an einer Aufsetzkante 244 mit einem Dammharz 242 versehen. Das Dammharz 242 kann beispielsweise bei den zum Aushärten des Formharzes 214 benötigten Temperaturen geringfügig fließfähig sein, so dass ein geringer, durch das Federelement 234 gesteuerter Anpressdruck des Sperraufsatzes 224 auf den Schaltungsträger 210 ausreicht, um eine zuverlässige Abdichtung des Bereiches 216 gegen die Moldmasse 214 zu gewährleisten, ohne dabei das empfindliche Bauelement 211, das Bauelement 210 oder die Leiterplatte 204 zu beschädigen. Auf diese Weise wird das Moldpackage 202 so ausgebildet, dass die Leiterplatte 204 vollständig und das Bauelement bzw. der Schaltungsträger 210 teilweise in die Moldmasse eingebettet sind, jedoch ein Bereich auf dem sekundären Schaltungsträger 210 mit dem sensitiven Element 211 freibleibt.

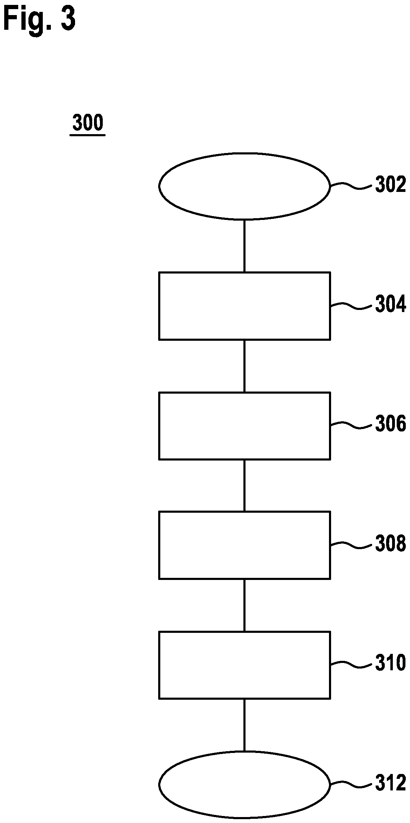

Ein detaillierteres Verfahren zur Herstellung des Moldmoduls 202 mittels des Werkzeuges 200 ist in dem Flussdiagramm 300 der Fig. 3 beispielhaft illustriert. Das Moldwerkzeug 200 dient der Herstellung des Moldmoduls 202 mit dem Schaltungsträger 210 und einem von dem Schaltungsträger 210 getragenen Bauelement 211, wobei die Moldmasse 214 den Schaltungsträger umschließt (302).

In Schritt 304 wird das Dammharz 242 bereitgestellt. Beispielsweise kann das Dammharz 242 auf der Aufsetzkante 244 des Sperraufsatzes 224 aufgebracht werden. Zusätzlich oder alternativ kann das Dammharz bei der Bestückung der Leiterplatte 204 mit dem Bauelement 210, der Bestückung des Bauelementes bzw. Schaltungsträgers 210 mit dem Bauelement 211, oder bei einer Vorbereitung der bestückten Leiterplatte 204 für den mittels des Werkzeuges 200 durchgeführten Moldprozesses auf einer Oberfläche des Elementes 210 aufgebracht werden, bspw. der Fläche, die auch das freizuhaltende Bauelement 211 trägt.

In Schritt 306 werden die Formteile des Werkzeugs 200 zusammengefügt, von denen in der Fig. 2 nur das Oberteil 220 gezeigt ist. Die Formteile bilden sodann einen Hohlraum 328, von dem in Fig. 2 nur der oberhalb der Leiterplatte 204 liegende Bereich veranschaulicht ist. In Schritt 308 wird der Sperraufsatz 224 auf den Bereich 216 abgesenkt. Nach dem Aufsetzen wird vermittelt durch das Federelement 234 eine ausreichende Anpresskraft ausgeübt, um zusammen mit dem für die Abdichtung eingesetzten Dammharz 242 den Bereich 216 während des weiteren Moldprozesses vom Harz 214 freizuhalten, ohne dass es zu Beschädigungen kommt und ohne dass hierfür eine außerordentliche Feinsteuerung des Anpressdruckes des Sperraufsatzes 224 oder sonstiger Prozessparameter erforderlich ist.

In Schritt 310 wird die Moldmasse 214 in den Hohlraum 228 eingefüllt, so dass dieser vollständig ausgefüllt ist, jedoch mit Ausnahme des durch den Sperraufsatz 224 gesperrten Bereiches 232, in den das zu schützende Bauelement 211 aufgenommen ist. Nach dem Aushärten der Moldmasse 214 werden in Schritt 312 das Formoberteil 220 sowie der Sperraufsatz 224 von dem fertiggestellten Moldpackage 202 abgehoben bzw. entfernt. Die Oberfläche 216 des Bauelementes bzw. sekundären Schaltungsträgers 210 mit dem darauf befindlichen sensitiven Element 211 liegen frei, während sonstige Bereiche der Leiterplatte 204 mitsamt dem Bauelement 208 vollständig von der Moldmasse 214 umgeben sind.

Die Erfindung ist nicht auf die hier beschriebenen Ausführungsbeispiele und die darin hervorgehobenen Aspekte beschränkt; vielmehr sind innerhalb des durch die anhängenden Ansprüche angegebenen Bereichs eine Vielzahl von Abwandlungen möglich, die im Rahmen fachmännischen Handelns liegen.

## Patentansprüche

1. Moldmodul (102, 202),
- mit einem Schaltungsträger (104, 210) und mindestens einem von dem Schaltungsträger getragenen Bauelement (106, 108, 110, 211),
- wobei eine Moldmasse (114, 214) den Schaltungsträger (104, 210) umschließt,
und wobei mindestens ein Bereich (116, 216) auf dem Schaltungsträger (104, 210) von der Moldmasse (114, 214) freigehalten ist und der Bereich (116, 216) mindestens ein Bauelement (110, 211) derart umfasst, dass das Bauelement (110, 211) freiliegt.

2. Moldmodul (102) nach Anspruch 1, wobei der Schaltungsträger eine Leiterplatte (104) umfasst.

3. Moldmodul (202) nach Anspruch 1 oder 2, wobei der Schaltungsträger ein erstes Bauelement (210) umfasst, wobei das erste Bauelement (210) als zweites Bauelement das freizuhaltende Bauelement (211) trägt.

4. Moldmodul (102, 202) nach einem der vorhergehenden Ansprüche, wobei das freizuhaltende Bauelement ein mechanisch und/oder thermisch empfindliches Bauelement (211) ist und/oder ein für einen Kontakt mit einer Umgebung vorgesehenes Bauelement (110).

5. Verfahren (300) zur Herstellung eines Moldmoduls (102, 202) mit einem Schaltungsträger (104, 210) und mindestens einem von dem Schaltungsträger getragenen Bauelement (106, 108, 110, 211), mit den folgenden Schritten:
- Aufsetzen (308) eines Sperraufsatzes (124, 224) auf den Schaltungsträger (104, 210), und
- Umschließen (310) des Schaltungsträgers (104, 210) mit einer Moldmasse (114, 214), wobei durch den Sperraufsatz (124, 224) ein Bereich (116, 216) auf dem Schaltungsträger von der Moldmasse (114, 214) freigehalten wird, wobei der Bereich (116, 216) mindestens ein Bauelement (110, 211) derart umfasst, dass das Bauelement (110, 211) freiliegend bleibt.

6. Verfahren nach Anspruch 5, wobei das Aufsetzen (308) des Sperraufsatzes (124, 224) entkoppelt von einem Zusammensetzen (306) von Formteilen erfolgt.

7. Verfahren nach Anspruch 5 oder 6, mit dem vorgelagerten Schritt des Aufbringens (304) von Dammharz (242) auf einen Aufsetzbereich auf dem Schaltungsträger, auf den der Sperraufsatz aufsetzt, und/oder eine Aufsetzkante (244) des Sperraufsatzes (242).

8. Werkzeug (100, 200) zur Herstellung eines Moldmoduls (102, 202) mit einem Schaltungsträger (104, 210) und mindestens einem von dem Schaltungsträger getragenen Bauelement (106, 108, 110, 211), wobei eine Moldmasse (114, 214) den Schaltungsträger umschließt, mit einem Sperraufsatz (124, 224) zum Aufsetzen auf den Schaltungsträger (104, 210), wobei der Sperraufsatz (124, 224) derart ausgebildet ist, dass mindestens ein Bereich (116, 216) auf dem Schaltungsträger von der Moldmasse (114, 214) freigehalten wird und der Bereich (116, 216) mindestens ein Bauelement (110, 211) derart umfasst, dass das Bauelement (110, 211) freiliegend bleibt.

9. Werkzeug (100, 200) nach Anspruch 8, wobei der Sperraufsatz (124, 224) eine Ausnehmung (132, 232) derart aufweist, dass beim Aufsetzen des Sperraufsatzes (124, 224) auf dem Schaltungsträger (104, 210) das freizuhaltende Bauelement (110, 211) in die Ausnehmung (132, 232) aufgenommen ist.

10. Werkzeug (100, 200) nach Anspruch 8 oder 9, wobei der Sperraufsatz (124, 224) von weiteren Komponenten (120, 220) des Werkzeugs derart entkoppelt ist, dass ein abdichtendes Aufsetzen ohne Beschädigung des Schaltungsträgers (104, 210) erfolgt.

11. Werkzeug (100, 200) nach Anspruch 10, wobei der Sperraufsatz (124, 224) federnd gelagert ist.
